# EUROPÄISCHE PATENTANMELDUNG

(11) **EP 3 686 612 A1**
(43) Veröffentlichungstag der Anmeldung: **29.07.2020**
(21) Anmeldenummer: 19153045.0
(22) Anmeldetag: 22.01.2019
(51) Int. Cl.: G01R 15/18

(54) **STROMSENSOR MIT VERBESSERTER HANDHABBARKEIT**

(71) Anmelder: Siemens Aktiengesellschaft, 80333 München (DE)
(72) Erfinder: Hartmann, Peter, 91301 Forchheim (DE); Hoffmann, Ingolf, 91074 Herzogenaurach (DE); Weiss, Roland, 91058 Erlangen (DE); Dietz, Gunnar, 90478 Nürnberg (DE); Itzke, Alexander, 90443 Nürnberg (DE)

(57) **Zusammenfassung**

Ein Stromsensor weist zwei Teilelemente (1,2) auf, die zueinander komplementäre Teile eines Kreisrings mit einem Kreisringmittelpunkt (3) bilden. Die Teilelemente (1,2) sind an ersten Enden (4,5) der Teilelemente (1,2) über ein Scharnier (6) gelenkig miteinander verbunden und dadurch um eine durch das Scharnier (6) definierte Achse (7) zwischen zwei Endlagen verschwenkbar. Zweite Enden (8,9) der Teilelemente (1,2) sind in der einen Endlage voneinander beabstandet, so dass der Kreisring geöffnet ist. In der anderen Endlage liegen sie aneinander an, so dass der Kreisring geschlossen ist. Die Teilelemente (1,2) weisen an ihren zweiten Enden (8,9) mechanisch miteinander zusammenwirkende Verbindungselemente (11,12) auf, über welche die Teilelemente (1,2) in der zweiten Endlage lösbar miteinander verbindbar sind. Auf den Teilelementen (1, 2) sind jeweils mehrere Magnetfeldsensoren (13) angeordnet, die gleichmäßig um den Kreisringmittelpunkt (3) herum verteilt angeordnet sind. Die Magnetfeldsensoren (13) sind über auf den Teilelementen (1,2) angeordnete Leitungen (14,16) mit einer auf einem der Teilelemente (1,2) angeordneten Energieversorgungseinrichtung (15) und einer auf demselben Teilelement (1) angeordneten Auswertungseinrichtung (17) verbunden. Die Magnetfeldsensoren (13) können ihre Sensorsignale (Sa bis Sh) somit der Auswertungseinrichtung (17) zuführen, welche bei geschlossenem Kreisring durch Auswertung der Sensorsignale (Sa bis Sh) der Magnetfeldsensoren (13) eine Stromstärke (I) eines sich innerhalb des Kreisrings befindlichen Leiters (10) ermittelt.

## Beschreibung

Die vorliegende Erfindung betrifft einen Stromsensor.

Stromsensoren sind in verschiedenen Ausgestaltungen bekannt. In der Regel bestehen die Stromsensoren aus einem geschlossenen, kreisringförmigen Element, durch das der Leiter, dessen Strom erfasst werden soll, hindurch geführt wird.

Diese Ausgestaltung weist verschiedene Nachteile auf. So ist beispielsweise für die Montage des Stromsensors eine besondere, aufwändige Mechanik des jeweiligen Leiters erforderlich, dessen Strom erfasst werden soll. Diese Mechanik benötigt viel Platz und ist teuer. Weiterhin müssen die Leiter demontierbar ausgebildet sein, damit der Stromsensor über den Leiter geführt werden kann. Durch die zusätzlichen Verbindungsstellen ergeben sich Übergangswiderstände und damit insbesondere bei höheren Strömen zusätzliche Verlustleistungen. Weiterhin hat die geometrisch-mechanische Führung des Leiters, dessen Strom erfasst werden soll, oftmals störende Auswirkungen auf die Erfassung des Stroms.

Aus dem Fachaufsatz "Crosstalk in Circular Arrays of Magnetic Sensors for Current Measurement" von R. Weiss et al., veröffentlicht in 16-TIE-2300, Seiten 1 bis 7, ist eine Sensoranordnung bekannt, bei der mehrere Magnetfeldsensoren regelmäßig auf einem Kreis um einen Leiter herum verteilt angeordnet sind. Die von den Magnetfeldsensoren erfassten Signale werden zusammengeführt und zusammen ausgewertet. Aus den von den Magnetfeldsensoren erfassten Signalen wird der Strom ermittelt, den der Leiter führt.

Aus dem Fachaufsatz "Current Measurement of Flat Conductors with a Circular Array of Magnetic Sensors" von R. Weiss et al. ist ein ähnlicher Offenbarungsgehalt bekannt.

Die Aufgabe der vorliegenden Erfindung besteht darin, einen verbesserten Stromsensor zu schaffen, der einfacher handhabbar ist als Stromsensoren des Standes der Technik und eine robuste Strommessung ermöglicht.

Die Aufgabe wird durch einen Stromsensor mit den Merkmalen des Anspruchs 1 gelöst. Vorteilhafte Ausgestaltungen des Stromsensors sind Gegenstand der abhängigen Ansprüche 2 bis 9.

Erfindungsgemäß wird ein Stromsensor geschaffen,
- bei dem der Stromsensor ein erstes und ein zweites Teilelement aufweist,
- bei dem das erste und das zweite Teilelement zueinander komplementäre Teile eines Kreisrings mit einem Kreisringmittelpunkt bilden,
- bei dem das erste und das zweite Teilelement an einem jeweiligen ersten Ende des ersten und des zweiten Teilelements über ein Scharnier gelenkig miteinander verbunden sind, so dass das zweite Teilelement relativ zum ersten Teilelement um eine durch das Scharnier definierte Achse zwischen einer ersten und einer zweiten Endlage verschwenkbar ist,
- bei dem jeweiligen zweiten Enden des ersten und des zweiten Teilelements in der ersten Endlage voneinander beabstandet sind, so dass der Kreisring geöffnet ist, und in der zweiten Endlage aneinander anliegen, so dass der Kreisring geschlossen ist,
- bei dem das erste und das zweite Teilelement an ihrem jeweiligen zweiten Ende mechanisch miteinander zusammenwirkende Verbindungselemente aufweisen, über welche das erste und das zweite Teilelement, wenn das zweite Teilelement sich in der zweiten Endlage befindet, lösbar miteinander verbindbar sind,
- bei dem auf dem ersten und dem zweiten Teilelement jeweils mehrere Magnetfeldsensoren angeordnet sind,
- bei dem die Magnetfeldsensoren gleichmäßig um den Kreisringmittelpunkt herum verteilt angeordnet sind,
- bei dem die Magnetfeldsensoren über auf dem ersten und dem zweiten Teilelement angeordnete erste Leitungen mit einer auf dem ersten Teilelement angeordneten Energieversorgungseinrichtung verbunden sind,
- bei dem die Magnetfeldsensoren über auf dem ersten und dem zweiten Teilelement angeordnete zweite Leitungen mit einer auf dem ersten Teilelement angeordneten Auswertungseinrichtung verbunden sind, so dass die Magnetfeldsensoren ihre Sensorsignale der Auswertungseinrichtung zuführen können, und
- bei dem die Auswertungseinrichtung derart ausgebildet ist, dass sie bei geschlossenem Kreisring durch Auswertung der Sensorsignale der Magnetfeldsensoren eine Stromstärke eines sich innerhalb des Kreisrings befindlichen Leiters ermittelt.

Durch die Ausgestaltung mit einem ersten und einem zweiten Teilelement kann - ähnlich wie bei Handschellen - der Stromsensor seitlich über den Leiter, dessen Strom erfasst werden soll, geführt werden. Das zweite Teilelement befindet sich hierbei in der ersten Endlage. Sodann wird das zweite Teilelement in die zweite Endlage überführt und dadurch der Kreisring geschlossen. Aufgrund der Verwendung mehrerer Magnetfeldsensoren, die auf beiden Teilelementen angeordnet sind, kann mit hoher Genauigkeit eine Stromerfassung erfolgen, obwohl eine geschlossene Ringspule oder eine andere ringförmig geschlossene magnetisch wirksame Komponente nicht vorhanden ist.

Vorzugsweise überdeckt das erste Teilelement bei geschlossenem Kreisring, bezogen auf den Kreisringmittelpunkt, einen Sektor von mindestens 90° und maximal 270°. Da das zweite Teilelement das zum ersten Teilelement komplementäre Teilelement ist und sich demzufolge das erste und das zweite Teilelement zum vollständigen Kreisring ergänzen, überdeckt auch das zweite Teilelement, bezogen auf den Kreisringmittelpunkt, einen Sektor von mindestens 90° und maximal 270°.

Die Magnetfeldsensoren können insbesondere als Hallsensoren oder als Fluxgatesensoren ausgebildet sein.

In einer bevorzugten Ausgestaltung weist der Stromsensor ein flexibles Leiterband auf, mittels dessen die auf dem zweiten Teilelement angeordneten ersten und zweiten Leitungen mit den auf dem ersten Teilelement angeordneten ersten Leitungen und einem Teil der auf dem ersten Teilelement angeordneten zweiten Leitungen elektrisch verbunden sind, so dass die Verbindung der entsprechenden Leitungen sowohl bei geöffnetem Kreisring als auch bei geschlossenem Kreisring besteht. Durch diese Ausgestaltung wird insbesondere eine permanente elektrische Verbindung bewirkt. Übergangswiderstände können minimiert werden.

In einer alternativen Ausgestaltung sind die auf dem zweiten Teilelement angeordneten ersten und zweiten Leitungen über eine Steckverbindung lösbar elektrisch mit den auf dem ersten Teilelement angeordneten ersten Leitungen und einem Teil der auf dem ersten Teilelement angeordneten zweiten Leitungen verbindbar und ist die Steckverbindung im Bereich der zweiten Enden des ersten und des zweiten Teilelements angeordnet. Diese Ausgestaltung weist insbesondere den Vorteil auf, dass beim Öffnen und Schließen des Kreisrings keine kontinuierlichen Bewegungen von Leitungsabschnitten, die auf Dauer zu Materialermüdung führen können, erfolgen müssen.

Vorzugsweise wird die Steckverbindung beim mechanischen Verbinden der Verbindungselemente automatisch mit hergestellt und beim Lösen der Verbindungselemente automatisch mit gelöst. Dadurch vereinfacht sich die Handhabung und kann insbesondere ein versehentliches Unterlassen des Herstellens der elektrischen Verbindung ausgeschlossen werden.

Vorzugsweise sind die Verbindungselemente Bestandteile einer Rast- oder Schnappverbindung. Eine derartige Verbindung ist besonders einfach handhabbar.

Vorzugsweise kapselt das erste Teilelement die auf ihm angeordneten Magnetfeldsensoren sowie die auf ihm angeordnete Energieversorgungseinrichtung und die auf ihm angeordnete Auswertungseinrichtung in einer hohen Schutzart und kapselt das zweite Teilelement die auf ihm angeordneten Magnetfeldsensoren in einer hohen Schutzart. Dadurch kann die elektrische Zuverlässigkeit des Stromsensors maximiert werden.

Vorzugsweise weisen das erste und das zweite Teilelement, bezogen auf den Kreisringmittelpunkt, radial außen Laschen auf, die ihrerseits Ausnehmungen zum Befestigen des Stromsensors aufweisen. Dadurch kann der Stromsensor auf einfache Weise innerhalb eines Geräts befestigt werden, in dem der Leiter angeordnet ist, dessen Strom erfasst werden soll.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Draufsicht auf einen Stromsensor mit einem zweiten Teilelement des Stromsensors in einer ersten Endlage,
- FIG 2: eine Draufsicht auf den Stromsensor von FIG 1 mit dem zweiten Teilelement in einer zweiten Endlage,
- FIG 3: eine perspektivische Darstellung des Stromsensors von FIG 1,
- FIG 4: zweite Enden des ersten und des zweiten Teilelements,
- FIG 5: eine Anordnung von Magnetfeldsensoren,
- FIG 6: eine weitere Anordnung von Magnetfeldsensoren,
- FIG 7: eine Verschaltung von Magnetfeldsensoren,
- FIG 8: eine weitere Verschaltung von Magnetfeldsensoren und
- FIG 9: eine Leitungsführung von ersten und zweiten Leitungen.

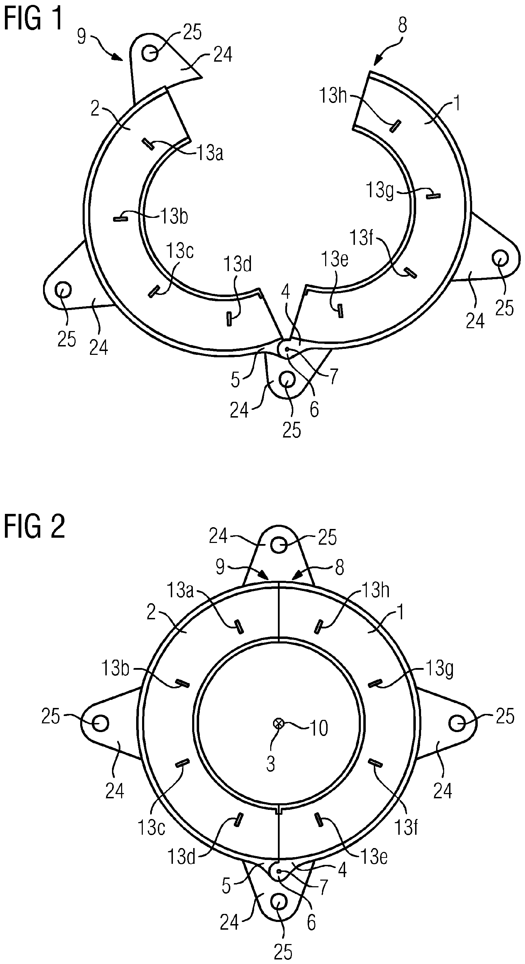

Gemäß den FIG 1 bis 3 weist ein Stromsensor ein erstes Teilelement 1 und ein zweites Teilelement 2 auf. Die beiden Teilelemente 1, 2 bilden, wie insbesondere aus FIG 2 erkennbar ist, zueinander komplementäre Teile eines Kreisrings, wobei der Kreisring einen Kreisringmittelpunkt 3 aufweist. Gemäß der Darstellung insbesondere in FIG 2 überdecken das erste und das zweite Teilelement 1, 2 bei geschlossenem Kreisring und bezogen auf den Kreisringmittelpunkt 3 jeweils einen Sektor von 180°, also einen Halbkreis. Diese symmetrische Aufteilung des Kreisrings ist in der Regel zu bevorzugen. Es ist aber auch eine asymmetrische Aufteilung möglich, bei welcher eines der beiden Teilelemente 1, 2 einen größeren Sektor überdeckt als das andere Teilelement 2, 1. Das erste Teilelement 1 sollte jedoch einen Sektor von mindestens 90° überdecken. Ebenso sollte auch das zweite Teilelement 2 einen Sektor von mindestens 90° überdecken. Dementsprechend sollte das erste Teilelement 1 einen Sektor von maximal 270° überdecken.

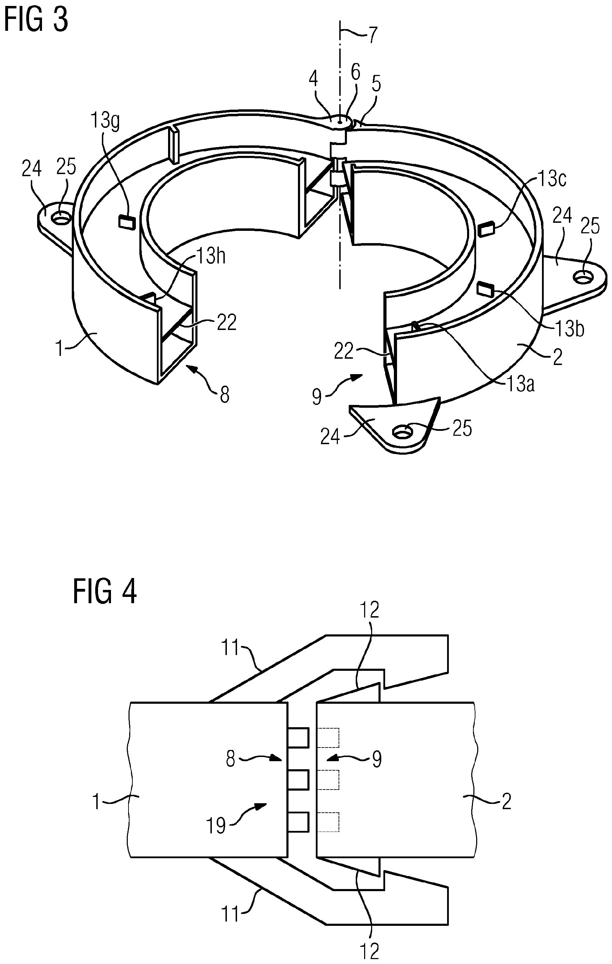

Das erste und das zweite Teilelement 1, 2 sind an einem jeweiligen ersten Ende 4, 5 über ein Scharnier 6 gelenkig verbunden. Das zweite Teilelement 2 ist dadurch relativ zum ersten Teilelement 1 um eine durch das Scharnier 6 definierte Achse 7 verschwenkbar. Die Achse 7 verläuft orthogonal zu der durch den Kreisring definierten Ebene. Das Verschwenken ist möglich zwischen einer ersten Endlage und einer zweiten Endlage. In der ersten Endlage - beispielsweise in der Stellung gemäß den FIG 1 und 3 - sind zweite Enden 8, 9 der beiden Teilelemente 1, 2 voneinander beabstandet. Der Kreisring ist also geöffnet. In der zweiten Endlage - siehe FIG 2 - liegen die zweiten Enden 8, 9 aneinander an. Der Kreisring ist also geschlossen.

Aufgrund der zweiteiligen Gestaltung des Stromsensors ist es auf einfache Weise möglich, den Stromsensor bei geöffnetem Kreisring über einen Leiter 10, dessen Strom I mittels des Stromsensors erfasst werden soll, zu führen und sodann den Kreisring zu schließen. In diesem Zustand - also bei geschlossenem Kreisring - erfolgt die Erfassung des Stromes I. Der geschlossene Zustand des Kreisrings stellt somit die Betriebsstellung des Stromsensors dar.

Um den Kreisring geschlossen zu halten, weisen das erste und das zweite Teilelement 1, 2 entsprechend der Darstellung in FIG 4 an ihrem jeweiligen zweiten Ende 8, 9 Verbindungselemente 11, 12 auf. Die Verbindungselemente 11, 12 wirken mechanisch miteinander zusammen. Über die Verbindungselemente 11, 12 können das erste und das zweite Teilelement 1, 2 bei geschlossenem Kreisring miteinander verbunden werden. Die Verbindung ist auch wieder lösbar. Beispielsweise können die Verbindungselemente 11, 12 entsprechend der Darstellung in FIG 4 Bestandteile einer Rast- oder Schnappverbindung sein. Es sind aber auch andere Ausgestaltungen der Verbindungselemente 11, 12 möglich, beispielsweise als Bestandteile einer Schraubverbindung.

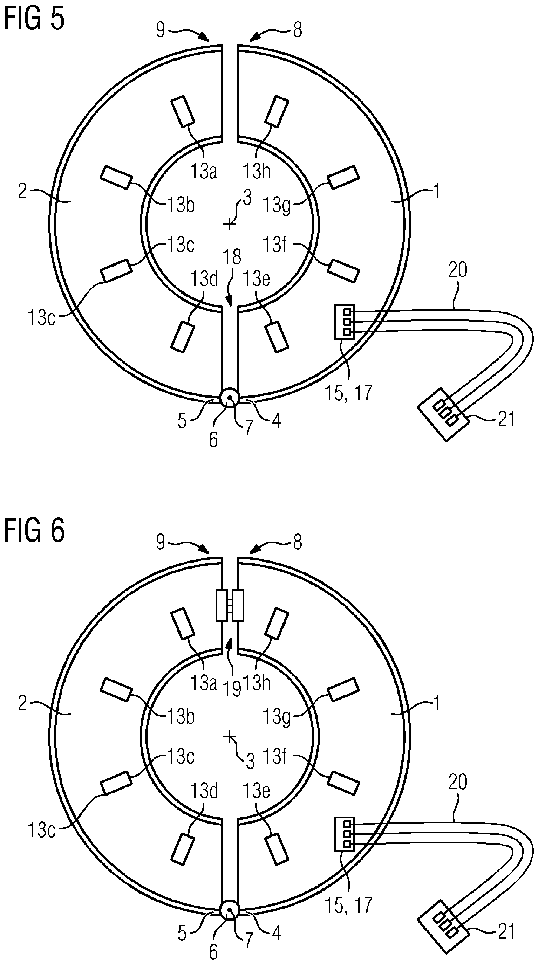

Entsprechend der Darstellung insbesondere in den FIG 5 und 6 sind auf dem ersten und dem zweiten Teilelement 1, 2 jeweils mehrere Magnetfeldsensoren 13 angeordnet. Die Magnetfeldsensoren 13 können beispielsweise als Hallsensoren oder als Fluxgatesensoren ausgebildet sein.

In der Regel sind auf jedem Teilelement 1, 2 mindestens zwei und höchstens fünf Magnetfeldsensoren 13 angeordnet. Gemäß der Darstellung in den FIG 5 und 6 sind auf jedem der beiden Teilelemente 1, 2 jeweils vier Magnetfeldsensoren 13 angeordnet. Die Magnetfeldsensoren 13 sind in den FIG 5 und 6 (und auch den anderen FIG, in denen die Magnetfeldsensoren 13 dargestellt sind) mit einem kleinen Buchstaben a bis h ergänzt, um sie bei Bedarf voneinander unterscheiden zu können.

Die Magnetfeldsensoren 13 sind gleichmäßig um den Kreisringmittelpunkt 3 herum verteilt angeordnet. Bei geschlossenem Kreisring bilden also jeweils zwei unmittelbar benachbarte Magnetfeldsensoren 13 - beispielsweise die Magnetfeldsensoren 13a und 13b oder die Magnetfeldsensoren 13a und 13h - mit dem Kreisringmittelpunkt 3 einen Winkel von 360°/n, wobei n die Anzahl an Magnetfeldsensoren 10 ist.

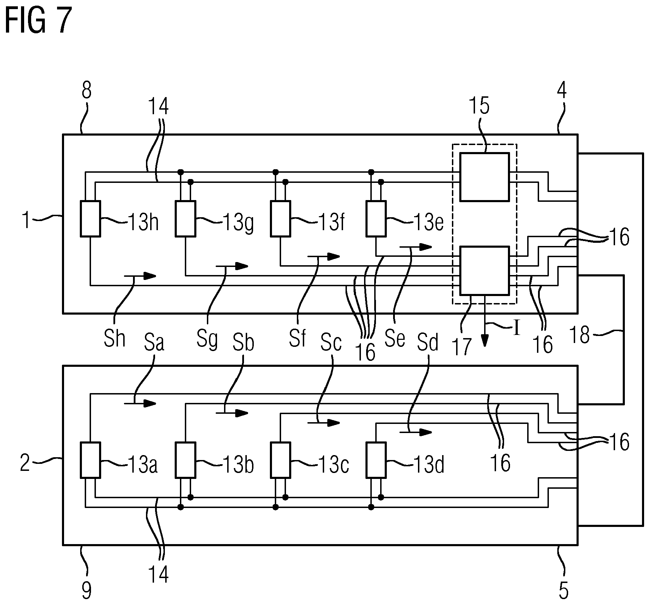

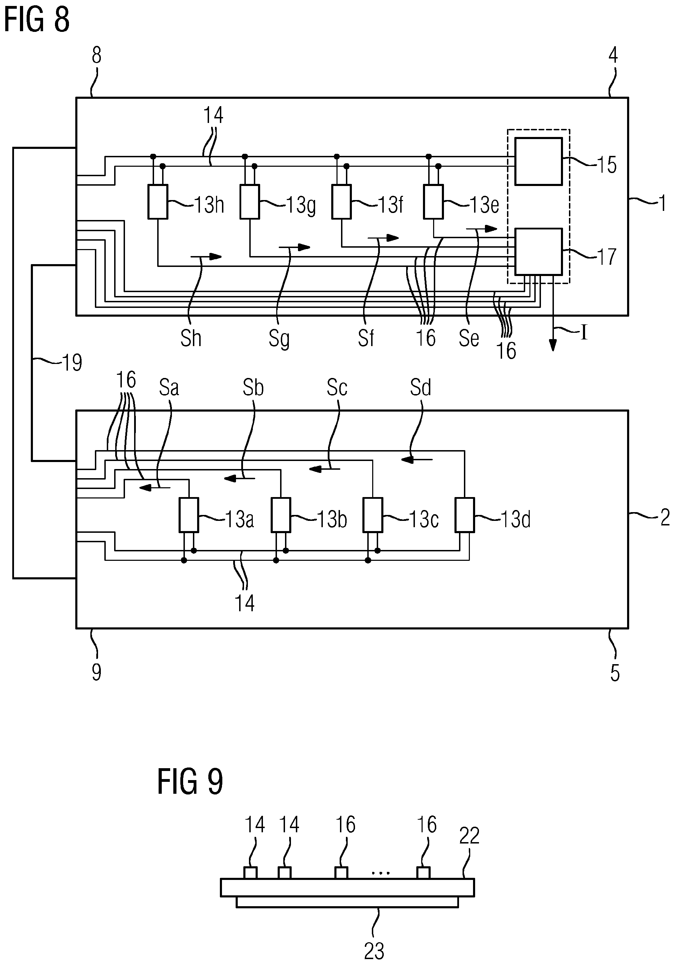

Die FIG 7 und 8 zeigen die Verschaltung der Magnetfeldsensoren 13 für die Ausgestaltung gemäß FIG 5 und 6. Gemäß der Darstellung in den FIG 7 und 8 sind die Magnetfeldsensoren 13 über erste Leitungen 14 mit einer Energieversorgungseinrichtung 15 verbunden. Die Energieversorgungseinrichtung 15 ist auf dem ersten Teilelement 1 angeordnet. Die Magnetfeldsensoren 13 sind weiterhin über zweite Leitungen 16 mit einer Auswertungseinrichtung 17 verbunden. Auch die Auswertungseinrichtung 17 ist auf dem ersten Teilelement 1 angeordnet. Über die zweiten Leitungen 16 können die Magnetfeldsensoren 13 somit der Auswertungseinrichtung 17 ihre Sensorsignale Sa bis Sh zuführen. Die Auswertungseinrichtung 17 kann mit der Energieversorgungseinrichtung 15 eine Einheit bilden. Dies ist in den FIG 5 und 6 dadurch angedeutet, dass die Energieversorgungseinrichtung 15 und die Auswertungseinrichtung 17 im selben Mikrochip angeordnet sind. In den FIG 7 und 8 ist dies durch eine gestrichelte Umrahmung angedeutet.

Die Auswertungseinrichtung 17 wertet die ihr zugeführten Sensorsignale Sa bis Sh aus. Die Art der Auswertung ist Fachleuten als solche bekannt. Rein beispielhaft kann auf die beiden bereits erwähnten Fachaufsätze von R. Weiss verwiesen werden. Die Auswertungseinrichtung 17 ermittelt somit - selbstverständlich bei geschlossenem Kreisring - durch Auswertung der Sensorsignale Sa bis Sh die Stromstärke I des Leiters 10.

Soweit die ersten und zweiten Leitungen 14, 16 auf dem ersten Teilelement 1 angeordnet sind, ist die Leitungsführung problemlos realisierbar. Soweit die ersten und zweiten Leitungen 14, 16 auf dem zweiten Teilelement 2 angeordnet sind, ist die Leitungsführung auf dem zweiten Teilelement 2 als solche ebenfalls problemlos realisierbar.

Um die auf dem zweiten Teilelement 2 angeordneten Magnetfeldsensoren 13 mit der Energieversorgungseinrichtung 15 und der Auswertungseinrichtung 17 zu verbinden, kann entsprechend der Darstellung in den FIG 5 und 7 ein flexibles Leiterband 18 vorhanden sein. Das Leiterband 18 verbindet die auf dem zweiten Teilelement 2 angeordneten ersten und zweiten Leitungen 14, 16 mit den zugehörigen ersten und zweiten Leitungen 14, 16 auf dem ersten Teilelement 1 elektrisch miteinander. Aufgrund des Leiterbandes 18 besteht die elektrische Verbindung der auf dem zweiten Teilelement 2 angeordneten Magnetfeldsensoren 13 mit der Energieversorgungseinrichtung 15 und der Auswertungseinrichtung 17 somit sowohl bei geöffnetem Kreisring als auch bei geschlossenem Kreisring. Entsprechende Ausgestaltungen des Leiterbandes 18 sind Fachleuten in Form sogenannter flexibler Leiterplatten allgemein bekannt.

Alternativ kann entsprechend der Darstellung in den FIG 6 und 8 zur Verbindung der auf dem zweiten Teilelement 2 angeordneten Magnetfeldsensoren 13 mit der Energieversorgungseinrichtung 15 und der Auswertungseinrichtung 17 eine Steckverbindung 19 vorhanden sein. Die Steckverbindung 19 ist gemäß den FIG 6 und 8 im Bereich der zweiten Enden 8, 9 des ersten und des zweiten Teilelements 1, 2 angeordnet. In diesem Fall sind die auf dem zweiten Teilelement 2 angeordneten ersten und zweiten Leitungen 14, 16 mit den zugehörigen ersten und zweiten Leitungen 14, 16 auf dem ersten Teilelement 1 über die Steckverbindung 19 lösbar elektrisch verbindbar. Vorzugsweise ist die Steckverbindung 19 entsprechend der Darstellung in FIG 4 derart angeordnet, dass sie beim mechanischen Verbinden der Verbindungselemente 11, 12 automatisch mit hergestellt wird und beim Lösen der Verbindungselemente 11, 12 automatisch mit gelöst wird.

Die Energieversorgungseinrichtung 15 muss mit elektrischer Energie versorgt werden. Auch muss der von der Auswertungseinrichtung 17 ermittelte Strom I nach außen abgeführt werden. Die Energieversorgungseinrichtung 15 und die Auswertungseinrichtung 16 können daher beispielsweise entsprechend der Darstellung in den FIG 5 und 6 ein kurzes Kabel 20 aufweisen, dessen Ende eine vorkonfektionierte Steckverbindung 21 trägt.

Um die elektromagnetische Störfestigkeit zu erhöhen, sind die ersten und zweiten Leitungen 14, 16 entsprechend der Darstellung in FIG 9 auf einer Seite einer jeweiligen Leiterplatte 22 angeordnet. Auf der anderen Seite der jeweiligen Leiterplatte ist entsprechend der Darstellung in FIG 7 vorzugsweise großflächig eine Schirmungsschicht 23 angeordnet. Die Schirmungsschicht 23 kann beispielsweise mit Masse oder Erde verbunden sein.

Das erste Teilelement 1 kapselt die auf ihm angeordneten Magnetfeldsensoren 13 sowie die auf ihm angeordnete Energieversorgungseinrichtung 15 und die auf ihm angeordnete Auswertungseinrichtung 17 vorzugsweise in einer hohen Schutzart, beispielsweise gemäß IP 44, IP 54 oder IP 65. In analoger Weise kapselt auch das zweite Teilelement 2 die auf ihm angeordneten Magnetfeldsensoren 13 in derselben hohen Schutzart. Gleiches gilt, soweit erforderlich, für die Ausgestaltung der Steckverbindung 19. Dadurch kann ein Eindringen von Schmutz und Feuchtigkeit und allgemein auch eine Beeinträchtigung der Funktion des Stromsensors vermieden werden.

Weiterhin weisen entsprechend der Darstellung in den FIG 1 bis 3 das erste und das zweite Teilelement 1, 2 radial außen Laschen 24 auf. Die Laschen 24 weisen ihrerseits Ausnehmungen 25 auf. Durch die Ausnehmungen 25 können Befestigungselemente (beispielsweise Schraubbolzen) geführt werden, so dass der Stromsensor über die Ausnehmungen 25 an einer anderen Struktur befestigt werden kann.

Zusammengefasst betrifft die vorliegende Erfindung somit folgenden Sachverhalt:
Ein Stromsensor weist zwei Teilelemente 1, 2 auf, die zueinander komplementäre Teile eines Kreisrings mit einem Kreisringmittelpunkt 3 bilden. Die Teilelemente 1, 2 sind an ersten Enden 4, 5 der Teilelemente 1, 2 über ein Scharnier 6 gelenkig miteinander verbunden und dadurch um eine durch das Scharnier 6 definierte Achse 7 zwischen zwei Endlagen verschwenkbar. Zweite Enden 8, 9 der Teilelemente 1, 2 sind in der einen Endlage voneinander beabstandet, so dass der Kreisring geöffnet ist. In der anderen Endlage liegen sie aneinander an, so dass der Kreisring geschlossen ist. Die Teilelemente 1, 2 weisen an ihren zweiten Enden 8, 9 mechanisch miteinander zusammenwirkende Verbindungselemente 11, 12 auf, über welche die Teilelemente 1, 2 in der zweiten Endlage lösbar miteinander verbindbar sind. Auf den Teilelementen 1, 2 sind jeweils mehrere Magnetfeldsensoren 13 angeordnet, die gleichmäßig um den Kreisringmittelpunkt 3 herum verteilt angeordnet sind. Die Magnetfeldsensoren 13 sind über auf den Teilelementen 1, 2 angeordnete Leitungen 14, 16 mit einer auf einem der Teilelemente 1, 2 angeordneten Energieversorgungseinrichtung 15 und einer auf demselben Teilelement 1 angeordneten Auswertungseinrichtung 17 verbunden. Die Magnetfeldsensoren 13 können ihre Sensorsignale Sa bis Sh somit der Auswertungseinrichtung 17 zuführen, welche bei geschlossenem Kreisring durch Auswertung der Sensorsignale Sa bis Sh der Magnetfeldsensoren 13 eine Stromstärke I eines sich innerhalb des Kreisrings befindlichen Leiters 10 ermittelt.

Die vorliegende Erfindung weist viele Vorteile auf. Insbesondere ist es auf sehr einfache Weise möglich, den Stromsensor zu montieren und gegebenenfalls auch wieder zu demontieren. Insbesondere ist keine Demontage des Leiters 10 erforderlich. Die Stromerfassung ist zuverlässig und genau. Die Störempfindlichkeit des Stromsensors ist deutlich reduziert. Es kann sowohl eine Erfassung eines Gleichstroms als auch eines Wechselstroms erfolgen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Stromsensor,
- wobei der Stromsensor ein erstes und ein zweites Teilelement (1,2) aufweist,
- wobei das erste und das zweite Teilelement (1,2) zueinander komplementäre Teile eines Kreisrings mit einem Kreisringmittelpunkt (3) bilden,
- wobei das erste und das zweite Teilelement (1,2) an einem jeweiligen ersten Ende (4,5) des ersten und des zweiten Teilelements (1,2) über ein Scharnier (6) gelenkig miteinander verbunden sind, so dass das zweite Teilelement (2) relativ zum ersten Teilelement (1) um eine durch das Scharnier (6) definierte Achse (7) zwischen einer ersten und einer zweiten Endlage verschwenkbar ist,
- wobei jeweilige zweite Enden (8,9) des ersten und des zweiten Teilelements (1,2) in der ersten Endlage voneinander beabstandet sind, so dass der Kreisring geöffnet ist, und in der zweiten Endlage aneinander anliegen, so dass der Kreisring geschlossen ist,
- wobei das erste und das zweite Teilelement (1,2) an ihrem jeweiligen zweiten Ende (8,9) mechanisch miteinander zusammenwirkende Verbindungselemente (11,12) aufweisen, über welche das erste und das zweite Teilelement (1,2), wenn das zweite Teilelement (2) sich in der zweiten Endlage befindet, lösbar miteinander verbindbar sind,
- wobei auf dem ersten und dem zweiten Teilelement (1,2) jeweils mehrere Magnetfeldsensoren (13) angeordnet sind,
- wobei die Magnetfeldsensoren (13) gleichmäßig um den Kreisringmittelpunkt (3) herum verteilt angeordnet sind,
- wobei die Magnetfeldsensoren (13) über auf dem ersten und dem zweiten Teilelement (1,2) angeordnete erste Leitungen (14) mit einer auf dem ersten Teilelement (1) angeordneten Energieversorgungseinrichtung (15) verbunden sind,
- wobei die Magnetfeldsensoren (13) über auf dem ersten und dem zweiten Teilelement (1,2) angeordnete zweite Leitungen (16) mit einer auf dem ersten Teilelement (1) angeordneten Auswertungseinrichtung (17) verbunden sind, so dass die Magnetfeldsensoren (13) ihre Sensorsignale (Sa bis Sh) der Auswertungseinrichtung (17) zuführen können, und
- wobei die Auswertungseinrichtung (17) derart ausgebildet ist, dass sie bei geschlossenem Kreisring durch Auswertung der Sensorsignale (Sa bis Sh) der Magnetfeldsensoren (13) eine Stromstärke (I) eines sich innerhalb des Kreisrings befindlichen Leiters (10) ermittelt.

2. Stromsensor nach Anspruch 1, **dadurch gekennzeichnet, dass** das erste Teilelement (1) bei geschlossenem Kreisring, bezogen auf den Kreisringmittelpunkt (3), einen Sektor von mindestens 90° und maximal 270° überdeckt.

3. Stromsensor nach Anspruch 1 oder 2, **dadurch gekennzeichnet, dass** die Magnetfeldsensoren (13) als Hallsensoren oder als Fluxgatesensoren ausgebildet sind.

4. Stromsensor nach Anspruch 1, 2 oder 3, **dadurch gekennzeichnet, dass** der Stromsensor ein flexibles Leiterband (18) aufweist, mittels dessen die auf dem zweiten Teilelement (2) angeordneten ersten und zweiten Leitungen (14,16) mit den auf dem ersten Teilelement (1) angeordneten ersten Leitungen (14) und einem Teil der auf dem ersten Teilelement (1) angeordneten zweiten Leitungen (16) elektrisch verbunden sind, so dass die Verbindung der entsprechenden Leitungen (14,16) sowohl bei geöffnetem Kreisring als auch bei geschlossenem Kreisring besteht.

5. Stromsensor nach Anspruch 1, 2 oder 3, **dadurch gekennzeichnet, dass** die auf dem zweiten Teilelement (2) angeordneten ersten und zweiten Leitungen (14,16) über eine Steckverbindung (19) lösbar elektrisch mit den auf dem ersten Teilelement (1) angeordneten ersten Leitungen (14) und einem Teil der auf dem ersten Teilelement (1) angeordneten zweiten Leitungen (16) verbindbar sind und dass die Steckverbindung (19) im Bereich der zweiten Enden (8,9) des ersten und des zweiten Teilelements (1,2) angeordnet ist.

6. Stromsensor nach Anspruch 5, **dadurch gekennzeichnet, dass** die Steckverbindung (19) beim mechanischen Verbinden der Verbindungselemente (11,12) automatisch mit hergestellt wird und beim Lösen der Verbindungselemente (11,12) automatisch mit gelöst wird.

7. Stromsensor nach einem der obigen Ansprüche, **dadurch gekennzeichnet, dass** die Verbindungselemente (11,12) Bestandteile einer Rast- oder Schnappverbindung sind.

8. Stromsensor nach einem der obigen Ansprüche, **dadurch gekennzeichnet, dass** das erste Teilelement (1) die auf ihm angeordneten Magnetfeldsensoren (13) sowie die auf ihm angeordnete Energieversorgungseinrichtung (15) und die auf ihm angeordnete Auswertungseinrichtung (17) in einer hohen Schutzart kapselt und dass das zweite Teilelement (2) die auf ihm angeordneten Magnetfeldsensoren (13) in einer hohen Schutzart kapselt.

9. Stromsensor nach einem der obigen Ansprüche, **dadurch gekennzeichnet, dass** das erste und das zweite Teilelement (1, 2), bezogen auf den Kreisringmittelpunkt (3), radial außen Laschen (24) aufweisen, welche Ausnehmungen (25) zum Befestigen des Stromsensors aufweisen.
